# EUROPÄISCHE PATENTSCHRIFT

(11) **EP 3 739 619 B1**
(45) Veröffentlichungstag und Bekanntmachung des Hinweises auf die Patenterteilung: **09.03.2022**
(21) Anmeldenummer: 20171131.4
(22) Anmeldetag: 23.04.2020
(51) Int. Cl.: H01L 21/67, H01L 21/677, H01L 21/683

(54) **PLATTENPRODUKTIONSANLAGE MIT AUSSTOSSEINRICHTUNG**
PLATE PRODUCTION SYSTEM WITH EJECTION DEVICE
INSTALLATION DE FABRICATION DE PLAQUES POURVUE DE DISPOSITIF DE REFOULEMENT

(30) Priorität: 17.05.2019 DE 102019113034
(43) Veröffentlichungstag der Anmeldung: 18.11.2020
(73) Patentinhaber: SR-Schindler Maschinen - Anlagetechnik GmbH, 93057 Regensburg Bayern (DE)
(72) Erfinder: STÖCKER, Robert, 93197 Zeitlarn (DE)
(74) Vertreter: Hannke, Christian

(56) Entgegenhaltungen:
- US-A1- 2007 068 454
- US-A1- 2010 107 405
- US-A1- 2017 323 814

## Beschreibung

Die vorliegende Erfindung bezieht sich auf eine Ausstoßeinrichtung, das heißt insbesondere eine Ausstoßeinrichtung zum Ausstoßen von gefertigten Platten aus einer Plattenproduktionsanlage. Derartige Plattenproduktionsanlagen sind aus dem Stand der Technik bekannt.

Das Dokument US 201732/3814 A1 offenbart eine Vorrichtung zum Laden von Wafern einer Polierwaferausrüstung, die mehrere Waferbevestigungs - oder Ablösungseinheiten aufweist, die in dem Randabschnitt einer Förderplatte ausgebildet sind, wobei die Waferausrichtungseinheit in der Förderplatte installiert ist.

Dabei ist es bekannt, dass in einer Pressform ein zu pressendes Material eingegeben wird und dieses mit einer Presseinrichtung zu den Platten gepresst wird. Insbesondere beschreibt die Erfindung eine sogenannte Ausstoßeinrichtung. Bei derartigen Ausstoßeinrichtungen handelt es sich in der Regel um diejenigen Einrichtungen, die die bereits gepresste Platte aus einer Form ausstoßen sollen.

Derartige Ausstoßeinheiten sind in der Regel in Ausstoßeinrichtungen angeordnet, bei denen es sich in der Regel um diejenigen Einrichtungen handelt, welche die bereits gepresste Platte aus einer Form ausstoßen sollen. Üblicherweise findet dies mittels eines Stempels, der von oben nach unten verfährt, durch Herausdrücken aus der Form statt.

Derartig produzierte Platten werden häufig mit einem gewünschten Mindestabstand nebeneinander verlegt. Hierbei werden in der Regel Abstandshalter verwendet, die zwischen den Platten angeordnet sind. Derartige Abstandshalter sollen nun verdeckt derart anordenbar sein, dass sie bei einer verlegten Platte seitlich im unteren Bereich der Platte und somit in verdeckter Position vorliegen. Um dies zu erreichen haben sich jedoch aus dem Stand der Technik bekannte Auspressvorgänge als weniger geeignet erwiesen.

Demzufolge liegt der vorliegenden Erfindung die Aufgabe zugrunde, eine Ausstoßeinheit für Plattenproduktionsanlagen zur Verfügung zu stellen, bei der auf einfache und schnelle Weise eine Entnahme und ein Ausstoßen möglich ist.

Insbesondere ist die erfindungsgemäße Vorrichtung bestimmt für Platten, welche derartige oben beschriebene Abstandshalter aufweisen.

Zu produzierende Platten für derartige Plattenproduktionsanlagen könnten z.B. Terrazzo, Betonbergsteinplatten, Pflastersteine in Hermetik-Qualität, Terrassen- und Gehwegplatten oder Einschicht- oder Zweischicht- oder Mehrschichtplatten mit kombiniertem Filter/Hermetik-Pressverfahren sein. Solche Produktionsplattenanlagen sind z.B. Hermetikpressen. Bei derartigen Hermetikpressen herrscht je nach Ausführung und Einstellung ein Pressdruck zwischen 4N/mm² und 20N/mm². Übliche Plattenstärken liegen beispielsweise zwischen 10 mm und 140 mm.

Eine erfindungsgemäße Vorrichtung zum Ausgeben von Platten weist einen Formenrahmen auf, der zur Aufnahme einer Platte (und/oder zur Aufnahme eines Materials, aus dem die Platte formbar ist) geeignet und bestimmt ist sowie eine Ausstoßeinheit, um die Platte aus dem Formenrahmen herauszudrücken, wobei die Ausstoßeinheit in einer vorgegebenen Verschieberichtung verschiebbar ist.

Erfindungsgemäß ist die Ausstoßeinheit zum Herausdrücken der Platten aus dem Formenrahmen in einer von unten nach oben gerichteten Bewegungsrichtung bewegbar und/oder die Ausstoßeinheit zum Herausdrücken der Platten aus dem Formenrahmen ist derart gegenüber dem Formenrahmen bewegbar, dass die Platten in einer von unten nach oben verlaufenden Richtung (bei der es sich insbesondere um die Verschieberichtung handelt) aus dem Formenrahmen herausdrückbar sind und die Vorrichtung weist eine oberhalb der Ausstoßeinrichtung angeordnete Halteeinrichtung zumindest zeitweise zum Halten der aus dem Formenrahmen herausgestoßenen Platte auf.

Es wird also im Gegensatz zum Stand der Technik vorgeschlagen, dass das Herausdrücken der gefertigten Platten durch eine Bewegung von unten nach oben erfolgt, d.h. genauer eine Bewegung der Ausstoßeinrichtung von unten nach oben. Dabei bedeutet grundsätzlich eine Bewegung von unten nach oben, dass zumindest eine Komponente dieser Bewegungsrichtung in einer vertikalen Richtung verläuft. Bevorzugt erfolgt das Ausstoßen der Platten in einer vertikalen Richtung von unten nach oben. Es wären jedoch auch leicht schräge Bewegungsrichtungen denkbar, beispielsweise Bewegungsrichtungen, die gegenüber der vertikalen Richtung um weniger als 20 ° Grad geneigt sind.

Dabei kann die Ausstoßeinheit einen Ausstoßstempel aufweisen, der auf die Herausdrückende Platte drückt und diese auf diese Weise aus dem Formenrahmen heraus drückt. Dabei ist es möglich, dass der Formenrahmen während dieses Herausdrückens stationär gehalten ist bzw. stationär angeordnet ist.

Es wäre auch möglich, dass nicht die Ausstoßeinrichtung sich in vertikaler Richtung nach oben bewegt sondern umgekehrt der Formenrahmen mit der darin gehaltenen Platte sich in einer vertikalen Richtung von oben nach unten bewegt.

In jedem Fall wirken der Formenrahmen und die Ausstoßeinheit daher derart zusammen, dass die Platte in einer vertikalen Richtung gegenüber dem Formenrahmen nach oben herausgedrückt wird.

Bei einer weiteren bevorzugten Ausführungsform weist die Halteeinrichtung wenigstens ein Vakuumhaltemittel auf. Dies bedeutet, dass der Halt der Platte an der Halteeinrichtung durch Beaufschlagung mit einem Vakuum erfolgt. Zu diesem Zweck kann die Halteeinrichtung eine Vielzahl von Saugeinheiten aufweisen, welche vorübergehend die zu haltende Platte ansaugen. So ist es beispielsweise möglich, dass eine oder mehrere Vakuumsaugknöpfe an die Platte angelegt werden und diese anschließend mit einem Unterdruck beaufschlagt werden.

Bei einer bevorzugten Ausführungsform weist daher die Halteeinrichtung eine Vakuumerzeugungseinheit auf, insbesondere eine Unterdruckerzeugungseinheit. Unter einem Vakuumhaltemittel wird allgemein ein Haltemittel verstanden, welches einen Unterdruck gegenüber einem Normaldruck nutzt, um die Platte zu halten. Vorteilhaft handelt es sich dabei um einen Druck, der unter 0,5 Bar, bevorzugt unter 0,4 Bar, bevorzugt unter 0,3 Bar, bevorzugt unter 0,2 Bar, bevorzugt unter 0,1 Bar und bevorzugt unter 0,05 Bar liegt.

Bevorzugt ist dieses genannte Vakuum einstellbar bzw. lösbar. So kann durch das beaufschlagen mit dem Vakuum eine Platte gegriffen werden, anschließend bewegt werden und schließlich das Vakuum wieder aufgehoben werden, beispielsweise um die Platte an einer gewünschten Position abzulegen.

Anstelle oder zusätzlich zu Vakuumhaltemitteln könnte jedoch die Halteeinrichtung jedoch auch Greifeinrichtungen, wie beispielsweise Greifarme aufweisen, welche die herausgedrückte Platte an ihren Seitenrändern greifen können. Vakuumhaltemittel haben jedoch den Vorteil, dass in der Umfangsrichtung um die Platte kein Raum verloren geht.

Bei einer weiteren bevorzugten Ausführungsform ist auch die Halteeinrichtung in der vertikalen Richtung bewegbar. So kann nach der Aufnahme einer Platte die Halteeinrichtung mit der Platte beispielsweise vertikal nach oben geführt werden, um so den Abstand zu dem Formenrahmen zu vergrößern.

Bei einer weiteren bevorzugten Ausführungsform ist die Halteeinrichtung an einer Trägereinrichtung angeordnet. Diese Trägereinrichtung kann dabei auch als Portalplatte bezeichnet werden. Besonders bevorzugt ist die Halteeinrichtung mittels Federeinrichtungen an der Trägereinrichtung angeordnet. Auf diese Weise kann ein Aufsetzen auf die Platte vereinfacht werden und schonender erfolgen. Bei diesen Federeinrichtungen könnte es sich beispielsweise um Spiralfedern oder dergleichen handeln, es könnte sich bei den Federeinrichtungen jedoch auch um pneumatische Federn handeln, welche die Halteeinrichtung gegenüber der Trägereinrichtung pneumatisch abfedern.

Bei einer weiteren bevorzugten Ausführungsform ist die Halteeinrichtung in einer von der Verschieberichtung abweichenden Richtung bewegbar. Insbesondere ist die Halteeinrichtung senkrecht zu der Verschieberichtung bewegbar, insbesondere in einer horizontalen Richtung. Auf diese Weise kann die Halteeinrichtung mit der daran angeordneten Platte von dem Formenrahmen wegbewegt werden um beispielsweise die Platte an einem anderen Ort abzulegen.

Bei einer bevorzugten Ausführungsform weist die Vorrichtung ein in der abweichenden Richtung bewegbaren Schlitten auf. Dieser Schlitten kann dabei verschiebbar gegenüber einem Träger angeordnet sein und die Bewegung der Halteeinrichtung in der abweichenden Richtung bewirken.

Bei einer weiteren bevorzugten Ausführungsform ist es möglich, dass der Formenrahmen in der Verschieberichtung stationär angeordnet ist. Es ist jedoch auch möglich und bevorzugt, dass der Formenrahmen auch in der Verschieberichtung beweglich ist und insbesondere in einer vertikalen Richtung beweglich.

Bei einer weiteren bevorzugten Ausführungsform weist die Vorrichtung eine Rütteleinrichtung auf. Diese kann ein Lockern der in dem Formenrahmen gehaltenen Platte bewirken, damit diese leichter gelöst werden kann. Diese Rütteleinrichtung kann dabei auch als Rüttelplatte bezeichnet werden. Die Rütteleinrichtung kann aber auch dazu dienen, dass zuvor in den Formenrahmen eingebrachte Material, aus dem die Platten gepresst werden, besser bzw. gleichmäßiger zu verteilen

Bei einer weiteren bevorzugten Ausführungsform ist die Ausstoßeinheit zwischen der Rütteleinrichtung und dem Formenrahmen angeordnet und insbesondere zumindest zeitweise dort angeordnet.

Es kann sich jedoch, wie oben erwähnt auch bevorzugt um eine andere Federeinrichtung, wie beispielsweise eine pneumatische Feder, handeln. So ist es möglich, dass die Ausstoßeinrichtung einen oberen Teil und einen unteren Teil aufweist, wobei gegenüber dem unteren Teil über mehrere Zwischenbauteile die Trägerplatte als Trägertisch gelagert sein kann. Wie oben erwähnt können Federeinrichtungen vorgesehen sein, die beispielsweis in einer vertikalen Richtung verlaufend angeordnet sind.

Die Ausstoßeinheit ist hierfür bevorzugt in einer vertikalen Richtung mit einer Hubeinrichtung ausgestattet und zusätzlich in einer vertikalen Richtung bevorzugt mit Federelementen ausgestattet.

In einem (üblicherweise zuvor stattfindenden) Pressvorgang, wird die Platte innerhalb der Form gepresst. Damit handelt es sich bei der hier beschriebenen Form insbesondere um eine Pressform. Bei diesem Pressvorgang erhält die Platte abhängig von der zur Verfügung stehenden Materialmenge unterschiedlich starke Plattenstärken, also eine unterschiedlich starke Höhe.

Bei einer weiteren bevorzugten Ausführungsform ist auch die Pressform bzw. der Formenrahmen in der Verschieberichtung stationär. Dies bedeutet, dass die Platte aus dieser Pressform herausgedrückt werden kann.

Bei einer weiteren bevorzugten Ausführungsform ist die erwähnte Verschieberichtung vertikal.

Bevorzugt ist wie oben erwähnt die Form eine Pressform, innerhalb derer die Platte pressbar ist. Dabei ist es möglich, dass die Platte von dieser Pressform in ihrer Umfangsrichtung eingefasst wird. Die Pressform kann dabei unterschiedliche geometrischen Gestalten aufweisen wie beispielsweise rechteckige Gestalten, eine kreisförmige Gestalt, eine quadratische Gestalt, oder eine ovale Gestalt.

Bei einer weiteren bevorzugten Ausführungsform presst die Ausstoßeinheit die Platte unter Berücksichtigung der Stärke der Platte aus der Form heraus. Dies bedeutet, dass auch ein Hubweg, bzw. Verschiebeweg der Stempeleinrichtung bzw. der Ausstoßeinrichtung in Abhängigkeit von einer Stärke der Platte ermittelt wird.

Bei einer weiteren bevorzugten Ausführungsform weist die Vorrichtung eine Messeinrichtung zum Messen der Plattenstärke auf. Diese Messeinrichtung kann sich im Bereich der hier beschriebenen Ausstoßeinrichtung befinden, sie kann jedoch auch vorgelagert sein, beispielsweise im Bereich einer Presseinrichtung, welche die Platten presst bzw. herstellt.

Bei einer weiteren bevorzugten Ausführungsform weist die Vorrichtung einen Abstandshalter auf, der beispielsweise in einem unteren Bereich der jeweils herauszudrückenden Platte angeordnet sein kann. Dieser Abstandshalter kann beispielsweise ein vollständiges Herausdrücken der Platte aus dem Formenrahmen gewährleisten.

Zusätzlich oder alternativ kann die Vorrichtung eine Eingabevorrichtung aufweisen, um eine gewünschte Plattenstärke einzugeben. Bei dieser Ausgestaltung hat der Benutzer die Möglichkeit, eine bestimmte Plattenstärke einzugeben und insbesondere die Bewegung des Distanzhalters auf diese Plattenstärke einzustellen. Dabei kann eine derartige Eingabe bevorzugt auch während eines laufenden Betriebs erfolgen.

Bei einer bevorzugten Ausführungsform weist die Vorrichtung einen in einer der abweichenden Richtung bewegbaren Schlitten auf. Bevorzugt ist an diesem Schlitten die Ausstoßeinrichtung angeordnet. Insbesondere ist an diesem Schlitten die Trägerplatte federnd angeordnet. Besonders bevorzugt ist die Trägerplatte an diesem Schlitten verstellbar in der Verschieberichtung angeordnet. Bei einer bevorzugten Ausführungsform weist die Vorrichtung eine Antriebseinrichtung, wie beispielsweise einen Spindelantrieb oder einen Pneumatikantrieb auf, der die Bewegung der Trägerplatte bezüglich dem Schlitten in der Verschieberichtung und/oder der hierzu senkrechten Richtung bewirkt.

Insbesondere wird durch die Trägerplatte mit zumindest einer Bewegungskomponente quer zur Verschieberichtung abtransportiert. Bevorzugt wird in einem Verfahrensschritt die Ausstoßeinrichtung auf die Platte zugestellt, insbesondere in der Verschieberichtung zugestellt. In anderen Worten erfolgt ein Verschieben der Ausstoßeinrichtung unter den Formenrahmen in der Verschieberichtung, d.h. auf den Formrahmen (mit der darin gehaltenen) Trägerplatte zu.

Die vorliegende Erfindung ist weiterhin auf eine Plattenproduktionsanlage mit einer Vorrichtung zum Ausgeben von Platten der obigen Art gerichtet. Vorteilhaft weist die Plattenproduktionsanlage auch eine Presseinrichtung auf, welche ein Material innerhalb einer Pressform zu den Platten presst.

Bei einer weiteren vorteilhaften Ausführungsform weist die Plattenproduktionsanlage auch eine Dosatoreinrichtung auf, welche das zu den Platten zu formende Material in die entsprechenden Formen eindosiert.

Bei einer weiteren bevorzugten Ausführungsform ist die Plattenproduktionsanlage als Rundläuferanlage ausgebildet. Dies bedeutet, dass die Plattenproduktionsanlage einen bewegbaren, insbesondere drehbaren Träger aufweist, und die einzelnen Arbeitsstationen, wie hier die Vorrichtung zum Ausgeben von Platten stationär bzgl. dieser Drehbewegung des Drehbahnträgers ausgebildet sind.

Daneben kann auch noch eine Mischeinrichtung vorgesehen sein, welche das in den Formenrahmen eingegebene Material mischt bzw. verteilt.

Die vorliegende Erfindung ist weiterhin auf ein Verfahren zum Ausgeben von Platten (insbesondere solchen Platten, welche einen Abstandshalter aufweisen und insbesondere solche Platten, welche in einem unteren Bereich derselben einen Abstandshalter aufweisen) gerichtet, wobei die Platten in einem Formenrahmen, der zur Aufnahme einer Platte geeignet und bestimmt ist, zur Verfügung gestellt und insbesondere gehalten werden, wobei mittels einer Ausstoßeinheit die Platte aus diesem Formenrahmen herausgedrückt wird, wobei die Ausstoßeinheit die Platte durch eine Bewegung in einer vorgegebenen Verschieberichtung ausstößt.

Erfindungsgemäß wird die Ausstoßeinheit zum Herausdrücken der Platte aus dem Formenrahmen in einer von unten nach oben gerichteten Bewegungsrichtung bewegt und/oder die Ausstoßeinheit wird derart gegenüber dem Formenrahmen bewegt dass die Platte in der von unten nach oben gerichteten Bewegungsrichtung aus dem Formenrahmen herausgedrückt wird und die aus dem Formenrahmen herausgestoßene Platte wird mittels einer oberhalb der Ausstoßeinheit angeordneten Halteeinrichtung wenigstens zeitweise gehalten.

Allgemein handelt es sich bei der Verschieberichtung um eine geradlinig verlaufende Richtung.

Bei einem bevorzugten Verfahren erfolgt das Halten der Platte mittels eines Unterdrucks bzw. mittels eines (Teil-) Vakuums. Bevorzugt wird die Halteeinrichtung mit der daran mittels eines Unterdrucks gehaltenen Platte bewegt und insbesondere sowohl in der Verschieberichtung als auch in einer hierzu senkrechten Richtung bewegt.

Bei einem bevorzugten Verfahren weist dieses die folgenden Verfahrensschritte auf. Zunächst wird die Ausstoßeinrichtung und/oder die Ausstoßeinheit unter die auszustoßende Platte zugestellt. Anschließend erfolgt ein Herauspressen der Platte aus dem Formenrahmen durch eine Bewegung der Ausstoßeinheit und/oder eine Bewegung des Formenrahmens in der Verschieberichtung (bzw. entgegengesetzt zu dieser).

In diesem Falle bewegt sich entweder die Ausstoßeinheit in der Verschieberichtung oder der Formenrahmen entgegen dieser Richtung. Auch wäre eine Kombination aus diesen beiden Bewegungen denkbar. In einem weiteren Verfahrensschritt erfolgt ein Zustellen der Halteeinrichtung auf die Platte entgegen der Verschieberichtung.

Bei einem weiteren bevorzugten Verfahren wird also die die Platte haltende Halteeinrichtung quer zur Verschieberichtung bewegt. Bei einem weiteren bevorzugten Verfahren wird die Platte von der Halteeinrichtung auf einen Träger abgelegt. Zu diesem Zweck kann die Platte wieder auf diesen Träger zugestellt werden und die Platte dann durch ein Lösen des Vakuums (oder allgemein einer Haltekraft) auf dem Träger abgelegt werden. Bevorzugt ist wie oben erwähnt die Halteeinrichtung gegenüber einem Träger federnd gelagert und insbesondere in der Verschieberichtung federnd gelagert.

Weitere vorteilhafte Ausführungsformen ergeben sich aus den beigefügten Zeichnungen:
Darin zeigen:
- Fig. 1: eine Plattenproduktionsanlage;
- Fig. 2: eine Darstellung einer Ausstoßeinheit;
- Fig. 3: eine Darstellung einer erfindungsgemäßen Vorrichtung in einer ersten Arbeitsposition;
- Fig. 4: vier Darstellungen der erfindungsgemäßen Vorrichtung in verschiedenen Arbeitspositionen;

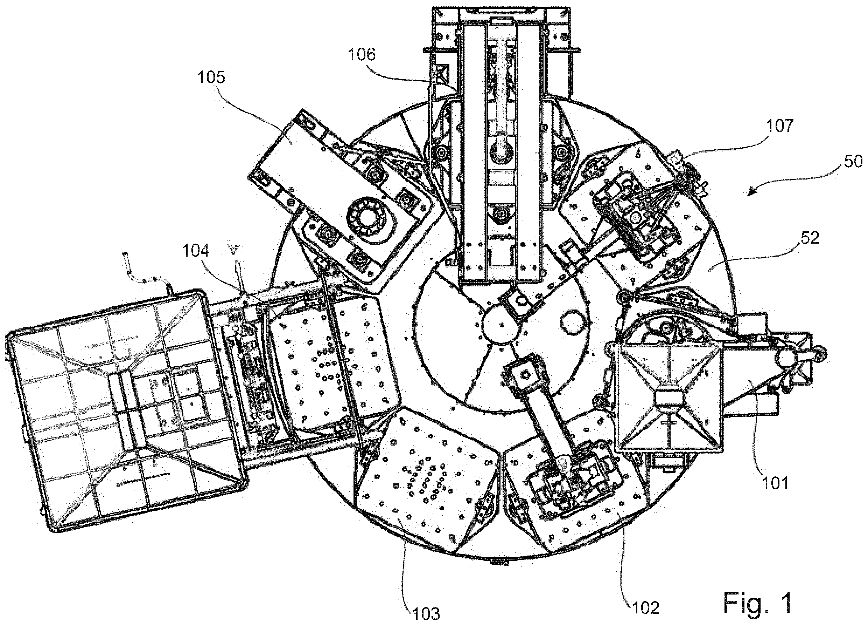

Fig. 1 zeigt eine erfindungsgemäße Plattenproduktionsanlage 50. Diese weist einen Drehteller auf, an dem eine Vielzahl von Bearbeitungsstationen angeordnet ist. Dabei bezieht sich dieses Bezugszeichen 101 auf eine Dosatoreinrichtung, welche das zuzuführende Material in eine Pressform dosiert.

Das Bezugszeichen 102 kennzeichnet eine Verteilstation, welche das durch die Dosiereinrichtung 101 in eine Form, beispielsweise eine Pressform eingefüllte Material verteilt bzw. eine gleichmäßige Verteilung dieses Materials bewirkt.

Das Bezugszeichen 103 bezieht sich auf eine Freistation. Diese kann besetzt werden, um zusätzliche, optionale Arbeitsschritte durchzuführen, beispielsweise zur Herstellung von Sondermodellen von Platten

Das Bezugszeichen 104 kennzeichnet eine Hinterbeton - Befüllstation. Diese kann beispielsweise eine weitere Materialschicht hinzufügen. Auf diese Weise können mehrschichtige Platten erzeugt werden. Bei der Herstellung von einschichtigen Platten kann diese Station auch entfallen.

Das Bezugszeichen 105 zeigt eine Vorverdichtungseinrichtung . Mittels dieser Station wird das in die Pressform eingefüllte Material (vor dem eigentlichen Pressvorgang) vorverdichtet.

Das Bezugszeichen 106 zeigt die Pressstation, in der die herzustellenden Platten gepresst werden.

Das Bezugszeichen 107 kennzeichnet eine Ausgabestation bzw. Entnahmestation, in der die gefertigten Platten aus ihrer Form entnommen bzw. herausgepresst werden.

Das Bezugszeichen 52 kennzeichnet einen drehbaren Transportträger. Mittels dieses Transportträgers wird das Material von einer Station im Taktbetrieb zu der nächsten Station transportiert. Die einzelnen Stationen 1 - 7 sind gegenüber dieser Drehbewegung des Transportträgers stationär angeordnet.

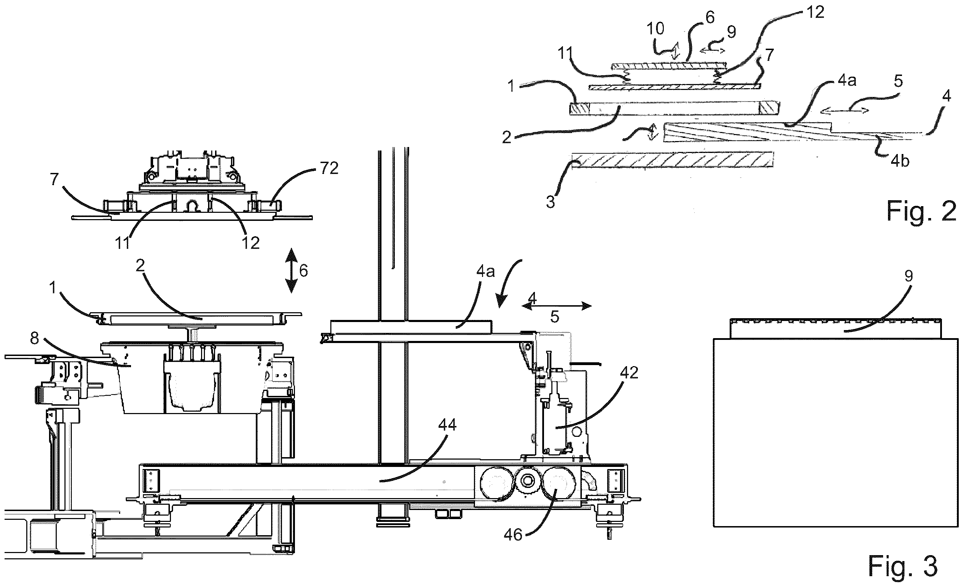

Hierfür weist - unter Bezugnahme auf Fig. 2, die eine schematische Darstellung eines Ausschnitts der Plattenproduktionsanlage im Querschnitt zeigt - eine derartige Plattenproduktionsanlage einen Formenrahmen 1 auf, in dem eine Platte 2 durch einen Pressvorgang geformt wird.

Sobald der Pressvorgang abgeschlossen ist, wird die Platte 2 innerhalb des Formenrahmens 1 und zusammen mit diesem von der Rüttelplatte 3 abgehoben, erfährt also eine Bewegung von unten nach oben.

Anschließend wird die Platte 2 von unten nach oben mittels einer Ausstoßeinheit 4 aus dem Formenrahmen ausgestoßen, indem die Ausstoßeinheit 4 mit einem Abschnitt 4a, der gegenüber einem Abschnitt 4b erhöht ausgebildet ist, zwischen dem Formenrahmen 1 und der Rüttelplatte 3 gemäß dem Pfeil 5 geschoben wird und anschließend gemäß dem Pfeil 6 nach oben gefahren wird, um die Platte 2 aus dem Formenrahmen 1 auszustoßen.

Somit ist die Ausstoßeinheit 4 sowohl in horizontaler Richtung gemäß dem Doppelpfeil 5 als auch in vertikaler Richtung gemäß dem Doppelpfeil 6 verfahrbar.

Der Abschnitt 4a der Ausstoßeinheit 4 ist in seiner Höhe und in seiner Längs- sowie Breitenrichtung einer Geometrie der Platte 2 und somit einer Ausnehmung innerhalb des Formenrahmens 1 angepasst, um eine passende und genaue Ausstoßung aus dem Formenrahmen 1 zu ermöglichen.

Eine parallel zu dem Formenrahmen 1 und der Platte 2 angeordnete Vakuumsaugplatte 7 wird zeitgleich während des Ausstoß- bzw. Ausdrückvorganges oder nach dem Ausstoß-bzw. Ausdrückvorgang der Platte 2 aus dem Formenrahmen 1 von oben auf die Platte 2 aufgesetzt. Diese Vakuumsaugplatte 7 kann somit zusammen mit einer Portalplatte 6 gemäß dem Doppelpfeil 10 in vertikaler Richtung von oben nach unten verfahren werden. Zwischen der Portalplatte 6 und der Vakuumsaugplatte 7 sind zudem Federelemente 11, 12 angeordnet, die ein federndes Auflegen der Vakuumsaugplatte 7 auf der anzusaugenden Platte 2 ermöglichen.

Sobald der Saugvorgang von Seiten der Vakuumsaugplatte 7 gegenüber der Platte 2 aktiviert worden ist, wird der Ausstoßvorgang der Platte von unten nach oben durch die Ausstoßeinheit 4 mittels einer Verfahrrichtung von unten nach oben durchgeführt. Zeitgleich wird die Vakuumsaugplatte gegen die Portalplatte 6 aufgrund der Federelemente 11, 12 federnd gedrückt und aktiviert zugleich den Saugvorgang zum Ansaugen der Platte 2 an der Unterseite der Vakuumsaugplatte 7.

Es wäre jedoch bevorzugt auch möglich, zuerst die Platte auszustoßen und diese erst anschließend mit der Saugeinrichtung abzuheben. Auf diese Weise kommt es nicht zu einem Überdrücken der Federn.

Die Federelemente dienen bei einer bevorzugten Ausführungsform und/oder beim einem bevorzugten Verfahren insbesondere und bevorzugt lediglich zum Ausgleichen von Toleranzen (bedingt beispielsweise durch eine Plattenstärke oder durch den Ausdrückvorgang.

Sobald die Platte 2 vollständig aus dem Formenrahmen 1 herausgedrückt worden ist, wird die Vakuumsaugplatte 7 zusammen mit der Portalplatte 6 gemäß dem Doppelpfeil 10 nach nach unten gefahren, das Vakuum angeschaltet und anschließend nach oben gefahren und anschließend gemäß dem Doppelpfeil entweder nach links oder nach rechts weitertransportiert, um die Platte 2 aus dem Bereich des Formenrahmens 1 heraus abzutransportieren. Anschließend findet durch eine Deaktivierung des Saugvorganges eine Ablage der Platte 2 in einem hier nicht näher dargestellten Bereich durch die Vakuumsaugplatte 7 statt.

Figur 3 zeigt eine Gesamtdarstellung der erfindungsgemäßen Vorrichtung. Auch hier ist wieder der Formenrahmen 1 erkennbar, in dem die Platte 2 angeordnet ist. Das Bezugszeichen 4 kennzeichnet die Ausstoßeinrichtung mit einem Ausstoßstempel 4a, der dazu dient, die Platte 2 aus dem Formenrahmen 1 herauszudrücken. Das Bezugszeichen 8 kennzeichnet die Rütteleinrichtung, die zum Teil bzw. zum Rütteln des Materials in dem Formenrahmen dient.

Das Bezugszeichen 72 kennzeichnet Vakuumerzeugungseinrichtungen wie Vakuumpumpen, welche ein Vakuum erzeugen, um die Platte an der Trägereinrichtung 7 anzusaugen.

Das Bezugszeichen 44 kennzeichnet einen Träger, an dem ein Schlitten 46 in der horizontalen Richtung 5 beweglich gelagert ist. Das Bezugszeichen 42 kennzeichnet eine Hubeinheit, die zum Heben und Senken der Ausstoßeinrichtung 4 dient. Das Bezugszeichen 9 kennzeichnet eine Ablageeinrichtung, auf der die gefertigten Platten von der Halteeinrichtung 7 abgelegt werden.

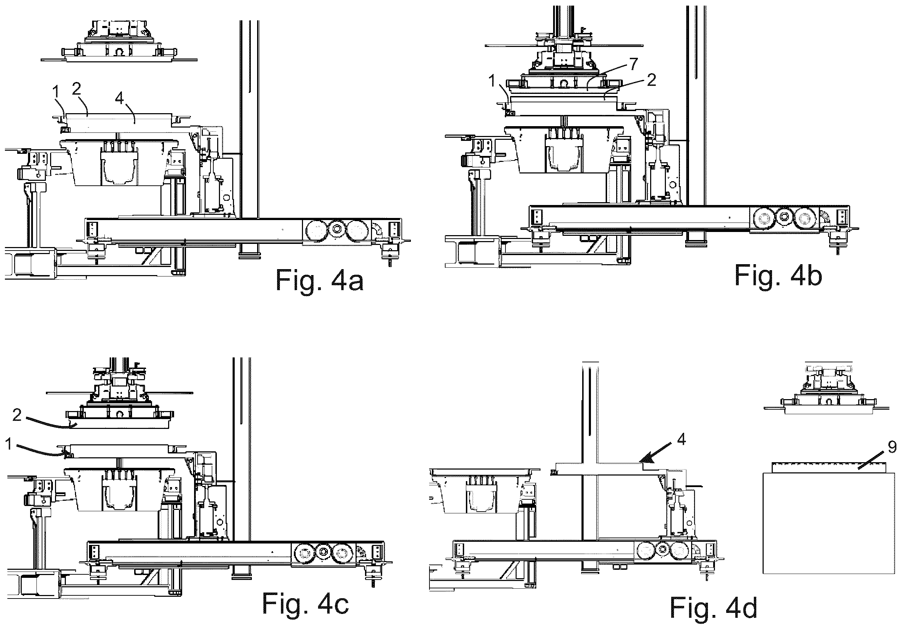

Die Figuren 4a - 4d zeigen vier Stationen während eines erfindungsgemäßen Verfahrens. Bei der in Figur 4a gezeigten Situation ist die Ausstoßeinrichtung 4 unter dem Formenrahmen 1 verbracht bzw. bewegt ?? und schiebt gerade die Platte 2 aus dem Formenrahmen 1 heraus.

Bei der in Figur 4b gezeigten Situation fährt die Halteeinrichtung 7 auf die Platte zu, um diese dann aufzunehmen.

Bei der in Figur 4c gezeigten Situation hat die Halteeinrichtung die Platte 2 aufgenommen und von dem Formenrahmen, der nun leer ist, abgehoben.

Ausgehend von der in Figur 4c gezeigten Situation werden sowohl die Ausstoßeinrichtung als auch die Trägereinrichtung 7 nach rechts verschoben. Bei der in Figur 4d gezeigten Situation ist die Ausstoßeinrichtung wieder in ihrer Grundstellung und die Trägereinrichtung mit der daran angeordneten Platte 2 ist oberhalb der Ablageeinrichtung 9, um die Platte dort abzulegen.

Die Erfindung wird durch die beigefügten Ansprüche definiert.

### Bezugszeichenliste

- 1: Formenrahmen
- 2: Platte
- 3: Rüttelplatte
- 4: Ausstoßeinheit
- 4a, 4b: Abschnitte der Ausstoßeinheit
- 5: horizontaler Richtung
- 6: Verschieberichtung
- 7: Trägereinrichtung
- 8: Rütteleinrichtung
- 9: Ablageeinrichtung
- 10: Doppelpfeil
- 11, 12: Federelemente
- 42: Hubeinheit
- 44: Träger
- 101: Dosatoreinrichtung
- 102: Verteilstation
- 103: Freistation
- 104: Hinterbeton - Befüllstation
- 105: Vorverdichtungseinrichtung
- 106: Pressstation
- 107: Vorrichtung

## Patentansprüche

1. Vorrichtung (107) zum Ausgeben von Platten (2) mit einem Formenrahmen (1) der zur Aufnahme einer Platte (2) geeignet und bestimmt ist, und mit einer Ausstoßeinheit (4), um die Platte (2) aus dem Formenrahmen (1) heraus zu drücken, wobei die Ausstoßeinheit (4) und/oder der Formenrahmen (1) in einer vorgegebenen Verschieberichtung (6) verschiebbar ist,
**dadurch gekennzeichnet, dass**
die Ausstoßeinheit zum Herausdrücken der Platten aus dem Formenrahmen derart gegenüber dem Formenrahmen (1) bewegbar ist, dass die Platten in einer von unten nach oben verlaufenden Richtung aus dem Formenrahmen (1) herausdrückbar sind und die Vorrichtung eine oberhalb der Ausstoßeinrichtung angeordnete Halteeinrichtung (7) zum wenigstens zeitweisen Halten der aus dem Formenrahmen herausgestoßenen Platte (2) aufweist.

2. Vorrichtung (107) nach Anspruch 1,
**dadurch gekennzeichnet, dass**
die Halteeinrichtung (7) wenigstens ein Vakuumhaltemittel aufweist.

3. Vorrichtung (107) nach wenigstens einem der vorangegangenen Ansprüche,
**dadurch gekennzeichnet, dass**
die Halteeinrichtung (7) in der vertikalen Richtung bewegbar ist.

4. Vorrichtung (107) nach wenigstens einem der vorangegangenen Ansprüche,
**dadurch gekennzeichnet, dass**
die Halteeinrichtung (7) an einer Trägereinrichtung (6) angeordnet ist.

5. Vorrichtung (107) nach dem vorangegangenen Anspruch,
**dadurch gekennzeichnet, dass**
die Halteeinrichtung (7) mittels Federeinrichtungen (11, 12) an der Trägereinrichtung (6) angeordnet ist.

6. Vorrichtung (107) nach wenigstens einem der vorangegangenen Ansprüche,
**dadurch gekennzeichnet, dass**
die Halteeinrichtung (7) in einer von der Verschieberichtung abweichenden Richtung (5) bewegbar ist.

7. Vorrichtung (107) nach dem vorangegangenen Anspruch,
**dadurch gekennzeichnet, dass**
die Vorrichtung einen in der abweichenden Richtung bewegbaren Schlitten aufweist.

8. Vorrichtung (107) nach wenigstens einem der vorangegangenen Ansprüche,
**dadurch gekennzeichnet, dass**
der Formenrahmen (1) in der Verschieberichtung beweglich angeordnet ist

9. Vorrichtung (107) nach wenigstens einem der vorangegangenen Ansprüche,
**dadurch gekennzeichnet, dass**
die Vorrichtung (107) eine Rütteleinrichtung aufweist.

10. Vorrichtung (107) nach dem vorangegangenen Ansnpruch,
**dadurch gekennzeichnet, dass**
die Ausstoßeinheit (4) zwischen der Rütteleinrichtung und dem Formenrahmen angeordnet ist

11. Verfahren zum Ausgeben von Platten (2) wobei die Platten in einem Formenrahmen (1), der zur Aufnahme einer Platte (2) geeignet und bestimmt ist, zur Verfügung gestellt werden und mittels einer Ausstoßeinheit (4) die Platte (2) aus diesem Formenrahmen herausgedrückt wird, wobei die Ausstoßeinheit (4) die Platte (2) durch eine Bewegung in einer vorgegebenen Verschieberichtung ausstößt,
**dadurch gekennzeichnet, dass**
die Ausstoßeinheit zum Herausdrücken der Platten aus dem Formenrahmen (1) in einer von unten nach oben gerichteten Bewegungsrichtung bewegt wird und/oder die Ausstoßeinheit (4) wird derart gegenüber dem Formenrahmen (1) bewegt dass die Platte (2) in der von unten nach oben gerichteten Bewegungsrichtung aus dem Formenrahmen (1) herausgedrückt wird und die aus dem Formenrahmen herausgestoßene Platte (2) mittels einer oberhalb der Ausstoßeinheit (4) angeordneten Halteeinrichtung (7) wenigstens zeitweise gehalten wird.

12. Verfahren nach Anspruch 11,
**dadurch gekennzeichnet, dass**
die Platte (2) mittels eines Unterdrucks an der Halteeinrichtung gehalten wird

13. Verfahren nach Anspruch 11 **gekennzeichnet durch** die folgenden Verfahrensschritte
- Zustellen der Ausstoßeinrichtung unter die auszustoßende Platte (2)
- Herauspressen der Platte (2) aus dem Formenrahmen (1) durch eine Bewegung der Ausstoßeinheit (4) in der Verschieberichtung.
- Zustellen der Halteeinrichtung auf die Platte entgegen der Verschieberichtung.

14. Verfahren nach dem vorangegangenen Anspruch, Anspruch 11-13,
**dadurch gekennzeichnet, dass**
die die Platte (2) haltende Halteeinrichtung (4) quer zur Verschieberichtung bewegt wird.

15. Verfahren nach wenigstens einem der vorangegangenen Ansprüche 11-14,
**dadurch gekennzeichnet, dass**
die Platte (2) von der Halteeinrichtung auf einem Träger abgelegt wird.

## Claims

1. Apparatus (107) for dispensing plates (2), comprising a mould frame (1), which is suitable and intended to accommodate a plate (2), and an ejection unit (4) in order to push the plate (2) out of the mould frame (1), wherein the ejection unit (4) and/or the mould frame (1) is displaceable in a predetermined displacement direction (6),
**characterised in that**
in order to push the plates out of the mould frame the ejection unit is movable relative to the mould frame (1) in such a way that the plates can be pushed out of the mould frame (1) in a direction extending upwards from below, and the apparatus has a holding device (7) arranged above the pushing device to at least temporarily hold the plate (2) ejected from the mould frame.

2. Apparatus (107) according to claim 1,
**characterised in that**
the holding device (7) has at least one vacuum holding means.

3. Apparatus (107) according to at least one of the preceding claims,
**characterised in that**
the holding device (7) is movable in the vertical direction.

4. Apparatus (107) according to at least one of the preceding claims,
**characterised in that**
the holding device (7) is arranged on a carrier device (6).

5. Apparatus (107) according to the preceding claim,
**characterised in that**
the holding device (7) is arranged on the carrier device (6) by means of spring devices (11, 12).

6. Apparatus (107) according to at least one of the preceding claims,
**characterised in that**
the holding device (7) is movable in a direction (5) different from the displacement direction.

7. Apparatus (107) according to the preceding claim,
**characterised in that**
the device has a slide which is movable in the different direction.

8. Apparatus (107) according to at least one of the preceding claims,
**characterised in that**
the mould frame (1) is arranged movably in the displacement direction.

9. Apparatus (107) according to at least one of the preceding claims,
**characterised in that**
the apparatus (107) has a vibrating device.

10. Apparatus (107) according to the preceding claim,
**characterised in that**
the ejection unit (4) is arranged between the vibrating device and the mould frame.

11. Method for dispensing plates (2), wherein the plates are provided in a mould frame (1) which is suitable and intended to accommodate a plate (2), and the plate (2) is pushed out of this mould frame by means of an ejection unit (4), wherein the ejection unit (4) ejects the plate (2) by a movement in a predetermined displacement direction,
**characterised in that**
in order to push the plates out of the mould frame (1) the ejection unit is moved in a direction extending upwards from below and/or the ejection unit (4) is moved relative to the mould frame (1) in such a way that the plate (2) is pushed out of the mould frame (1) in the direction extending upwards from below, and the plate (2) ejected from the mould frame is at least temporarily held by means of a holding device (7) arranged above the ejection unit (4).

12. Method according to claim 11,
**characterised in that**
the plate (2) is held on the holding device by means of a negative pressure.

13. Method according to claim 11,
**characterised by** the following method steps:
- delivering the ejection device below the plate (2) to be ejected,
- pressing the plate (2) out of the mould frame (1) by a movement of the ejection unit (4) in the displacement direction,
- delivering the holding device onto the plate contrary to the displacement direction.

14. Method according to the preceding claim, claim 11-13,
**characterised in that**
the holding device (4) holding the plate (2) is moved transversely with respect to the displacement direction.

15. Method according to at least one of the preceding claims,
**characterised in that**
the plate (2) is set down on a carrier by the holding device.

## Revendications

1. Dispositif (107) destiné à distribuer des plaques (2) avec un cadre de moulage (1) qui est conçu et déterminé pour recevoir une plaque (2), et avec une unité d'expulsion (4) pour pousser la plaque (2) hors du cadre de moulage (1), dans lequel l'unité d'expulsion (4) et/ou le cadre de moulage (1) peut être coulissé(e) dans une direction de coulissement (6) prédéfinie,
**caractérisé en ce que**
l'unité d'expulsion peut être déplacée par rapport au cadre de moulage (1) pour pousser les plaques hors du cadre de moulage de telle sorte que les plaques puissent être poussées hors du cadre de moulage (1) dans une direction orientée du bas vers le haut et le dispositif présente un équipement de maintien (7) agencé au-dessus de l'unité d'expulsion pour maintenir au moins temporairement la plaque (2) poussée hors du cadre de moulage.

2. Dispositif (107) selon la revendication 1,
**caractérisé en ce que**
l'équipement de maintien (7) comporte au moins un moyen de maintien sous vide.

3. Dispositif (107) selon au moins l'une des revendications précédentes,
**caractérisé en ce que**
l'équipement de maintien (7) peut être déplacé dans la direction verticale.

4. Dispositif (107) selon au moins l'une des revendications précédentes,
**caractérisé en ce que**
l'équipement de maintien (7) est disposé contre un équipement de support (6).

5. Dispositif (107) selon la revendication précédente,
**caractérisé en ce que**
l'équipement de maintien (7) est disposé contre l'équipement de support (6) au moyen de dispositifs à ressort (11, 12).

6. Dispositif (107) selon au moins l'une des revendications précédentes,
**caractérisé en ce que**
l'équipement de maintien (7) peut être déplacé dans une direction (5) qui diverge de la direction de coulissement.

7. Dispositif (107) selon la revendication précédente,
**caractérisé en ce que**
le dispositif présente un coulisseau pouvant être déplacé dans la direction qui diverge.

8. Dispositif (107) selon au moins l'une des revendications précédentes,
**caractérisé en ce que**
le cadre de moulage (1) est agencé de façon mobile dans la direction de coulissement.

9. Dispositif (107) selon au moins l'une des revendications précédentes,
**caractérisé en ce que**
le dispositif (107) présente un dispositif vibrant.

10. Dispositif (107) selon la revendication précédente,
**caractérisé en ce que**
l'unité d'expulsion (4) est agencée entre le dispositif vibrant et le cadre de moulage.

11. Procédé destiné à distribuer des plaques (2), dans lequel les plaques sont mises à disposition dans un cadre de moulage (1) qui est conçu et déterminé pour recevoir une plaque (2), et une plaque (2) est poussée hors de ce cadre de moulage au moyen d'une unité d'expulsion (4), dans lequel l'unité d'expulsion (4) pousse la plaque (2) en dehors par un mouvement dans une direction de coulissement prédéfinie,
**caractérisé en ce que**
l'unité d'expulsion est déplacée pour pousser les plaques hors du cadre de moulage (1) dans une direction de mouvement orientée du bas vers le haut et/ou l'unité d'expulsion (4) est déplacée par rapport au cadre de moulage (1) de telle sorte que la plaque (2) soit poussée hors du cadre de moulage (1) dans la direction de mouvement orientée du bas vers le haut, et la plaque (2) poussée hors du cadre de moulage est maintenue au moins temporairement au moyen d'un équipement de maintien (7) agencé au-dessus de l'unité d'expulsion (4).

12. Procédé selon la revendication 11,
**caractérisé en ce que**
la plaque (2) est maintenue au moyen d'une dépression au niveau de l'équipement de maintien.

13. Procédé selon la revendication 11,**caractérisé par** les étapes de procédé suivantes consistent à
- placer l'unité d'expulsion sous la plaque (2) à expulser
- pousser la plaque (2) hors du cadre de moulage (1) par un mouvement de l'unité d'expulsion (4) dans la direction de coulissement (6)
- placer l'équipement de maintien sur la plaque à contre-sens de la direction de coulissement.

14. Procédé selon l'une des revendications précédentes, revendication 11-13,
**caractérisé en ce que**
l'équipement de maintien (7) maintenant la plaque (2) est déplacé transversalement à la direction de coulissement.

15. Procédé selon au moins l'une des revendications précédentes 11-14,
**caractérisé en ce que**
la plaque (2) est déposée sur un support par l'équipement de maintien.
